# EUROPÄISCHE PATENTSCHRIFT

(11) **EP 3 356 867 B1**
(45) Veröffentlichungstag und Bekanntmachung des Hinweises auf die Patenterteilung: **26.03.2025**
(21) Anmeldenummer: 16770476.6
(22) Anmeldetag: 20.09.2016
(51) Int. Cl.: G02B 5/08

(54) **REFLEKTIVES OPTISCHES ELEMENT**
REFLECTIVE OPTICAL ELEMENT
ÉLÉMENT OPTIQUE RÉFLÉCHISSANT

(30) Priorität: 29.09.2015 DE 102015218763
(43) Veröffentlichungstag der Anmeldung: 08.08.2018
(73) Patentinhaber: Carl Zeiss SMT GmbH, 73447 Oberkochen (DE)
(72) Erfinder: WEIGL, Frank, 89438 Holzheim (DE); FORCHT, Konstantin, 73430 Aalen (DE); FELDERMANN, Horst, 73432 Aalen (DE)
(74) Vertreter: Werner & ten Brink
(86) Internationale Anmeldenummer: PCT/EP2016/072246
(87) Internationale Veröffentlichungsnummer: WO 2017/055133

(56) Entgegenhaltungen:
- EP-A1- 1 152 263
- WO-A1-2015/039705
- DE-A1- 102012 221 186
- JP-A- 2004 260 080
- JP-A- 2006 227 099
- US-A- 4 320 936
- US-A- 5 400 179
- US-A- 5 850 309
- US-A- 5 993 898
- US-A1- 2006 262 389
- US-A1- 2008 158 702
- US-A1- 2008 247 044

## Beschreibung

Die vorliegende Erfindung bezieht sich auf ein reflektives optisches Element für eine Betriebswellenlänge im DUV- oder VUV-Wellenlängenbereich, aufweisend ein Substrat, ein dielektrisches Schichtsystem und eine metallische Beschichtung zwischen dem Substrat und dem dielektrischen Schichtsystem, bei dem das dielektrische Schichtsystem mindestens jeweils eine Schicht aus einem Material mit einem niedrigeren Brechungsindex n1 bei der Betriebswellenlänge, eine Schicht aus einem Material mit einem höheren Brechungsindex n2 bei der Betriebswellenlänge und eine Schicht aus einem Material mit einem Brechungsindex n3 bei der Betriebswellenlänge aufweist mit n1<n3<n2, wobei an mindestens einem Übergang von einer Schicht mit einem niedrigeren Brechungsindex n1 zu einer Schicht mit einem höheren Brechungsindex n2 bzw. von einer Schicht mit einem höheren Brechungsindex n2 zu einer Schicht mit einem niedrigeren Brechungsindex n1 eine Schicht mit einem mittleren Brechungsindex n3 angeordnet ist. Ferner bezieht sich die Erfindung auf ein optisches System, eine Lithographievorrichtung und eine Mikroskopievorrichtung mit einem solchen reflektiven optischen Element.

Unter anderem werden in der Mikrolithographie mit tief ultravioletter Strahlung (DUV-Strahlung) bzw. Vakuum-ultravioletter Strahlung (VUV-Strahlung), insbesondere bei Wellenlängen zwischen 150 nm und 300 nm in optischen Systemen neben Linsen auch dielektrische Spiegel eingesetzt. Als Strahlungsquelle dient dabei oft ein Excimer-Laser, der in diesem Wellenlängenbereich emittiert. Besonders verbreitet sind u.a. Excimer-Laser, die bei 193 nm oder bei 248 nm emittieren. Aus der US 5,850,309 ist ein reflektives optisches Element aufweisend ein Substrat, ein dielektrisches Schichtsystem und eine metallische Beschichtung zwischen dem Substrat und dem dielektrischen Schichtsystem bekannt. Die metallische Beschichtung dient primär der breitbandigen Reflexion. Das dielektrische Schichtsystem dient dazu, die Eigenschaften des reflektiven optischen Elements zu verbessern. Dazu gehören beispielsweise die Reflektivität bei der Betriebswellenlänge, der Polarisationsgrad der reflektierten Strahlung oder auch die Beständigkeit der metallischen Beschichtung gegenüber der DUV-Strahlung und anderen Umwelteinflüssen. Das in der US 5,850,309 beschriebene dielektrische Schichtsystem ist abwechselnd aus hoch- und niedrigbrechenden Materialien aufgebaut. Es kann in Unterblöcke aufgeteilt sein, wobei in unterschiedlichen Unterblöcken verschiedene Materialien als niedrig- bzw. hochbrechende Schichten eingesetzt werden. Dadurch werden gegenüber reflektiven optischen Elementen mit metallischer Beschichtung und ohne dielektrisches Schichtsystem erhöhte Reflektivitäten bei der Betriebswellenlänge, d.h. der Wellenlänge der Strahlungsquelle, für die das jeweilige reflektive optische Element optimiert ist, bei gleichzeitig erhöhter Laserbeständigkeit erreicht.

Die WO 2015/039705 A1 offenbart einen Viellagenspiegel für den extrem ultravioletten Wellenlängenbereich, der in einer Ausführungsform ein Viellagensystem aus einem sich wiederholenden Stapel aus einem Material mit einem hohen Realteil des Brechungsindex (H), aus einem Material mit einem niedrigen Realteil des Brechungsindex (L) und einem Material mit dazwischenliegendem Realteil des Brechungsindex (IM) aufweisen kann, so dass sich die Lagenfolge H-IM-L-IM-H-IM-L... ergibt. Dadurch wird erreicht, dass der Spiegel bei genau zwei Wellenlängen aus dem extrem ultravioletten Wellenlängenbereich ein Reflektivitätsmaximum aufweist.

Aus der US 2011/0206859 A1 ist ein gattungsgemäßes reflektives optisches Element bekannt, bei dem zwischen mindestens zwei Perioden aus fluoridischen hoch- und niedrigbrechenden Schichten eine amorphe Schicht aus Siliziumdioxid oder dotiertem Siliziumdioxid vorgesehen ist.

In der JP 2006-227099 A wird wie in der US 5,850,309 ein reflektives optisches Element für den UV-Wellenlängenbereich beschrieben, das ein Substrat, ein dielektrisches Schichtsystem und eine metallische Beschichtung zwischen dem Substrat und dem dielektrischen Schichtsystem aufweist.

In der US 2008/247044 A1 werden reflektive optische Elemente für die Lithographie für den Einsatz im sichtbaren Wellenlängenbereich zur Herstellung von LCDs beschrieben. Diese reflektiven optischen Elemente weisen keine Metallverspiegelung, sondern nur eine dielektrische Mehrlagenbeschichtung auf, die dafür ausgelegt ist, besondere Polarisationseigenschaften aufzuweisen.

Es ist eine Aufgabe der vorliegenden Erfindung, das bekannte reflektive optische Element weiterzuentwickeln.

Diese Aufgabe wird gelöst durch ein reflektives optisches Element für eine Betriebswellenlänge zwischen 150 nm und 300 nm im DUV- oder VUV-Wellenlängenbereich, aufweisend ein Substrat, ein dielektrisches Schichtsystem und eine metallische Beschichtung zwischen dem Substrat und dem dielektrischen Schichtsystem, bei dem das dielektrische Schichtsystem eine Schicht aus einem Material mit einem niedrigeren Brechungsindex n1 bei der Betriebswellenlänge sowie eine Schicht aus einem Material mit einem höheren Brechungsindex n2 bei der Betriebswellenlänge aufweist, wobei das dielektrische Schichtsystem des Weiteren Schichten aus einem Material mit einem Brechungsindex n3 bei der Betriebswellenlänge aufweist mit n1<n3<n2, wobei an Übergängen von einer Schicht mit dem niedrigeren Brechungsindex n1 zu einer Schicht mit dem höheren Brechungsindex n2 bzw. von einer Schicht mit dem höheren Brechungsindex n2 zu einer Schicht mit einem niedrigeren Brechungsindex n1 eine Schicht mit dem mittleren Brechungsindex n3 angeordnet ist, derart dass das dielektrische Schichtsystem eine Vierschichtenabfolge von (LMHM)m oder (HMLM)m mit L der Schicht aus einem Material mit einem niedrigeren Brechungsindex n1 bei der Betriebswellenlänge, H der Schicht aus einem Material mit einem höheren Brechungsindex n2 bei der Betriebswellenlänge und M jeweils der Schicht aus einem Material mit einem Brechungsindex n3 bei der Betriebswellenlänge aufweist und wobei n1<n3<n2 sowie m die Anzahl der Vierschichtenabfolge im dielektrischen Schichtsystem ist, wobei für eine Betriebswellenlänge im Bereich zwischen 240 nm und 300 nm die mindestens eine Schicht (L) aus einem Material mit einem niedrigeren Brechungsindex n1 aus einem oder mehreren Materialien der Gruppe Aluminiumfluorid, Kryolith, Chiolith, Lithiumfluorid und Magnesiumfluorid ist, die mindestens eine Schicht (H) aus einem Material mit einem höheren Brechungsindex n2 aus einem oder mehreren Materialien der Gruppe Yttriumoxid, Hafniumoxid, Scandiumoxid, Zirkoniumoxid, Aluminiumnitrid und synthetischem Diamant ist und die Schichten (M) aus einem Material mit einem mittleren Brechungsindex n3 aus einem oder mehreren Materialien der Gruppe Bariumfluorid, Gadoliniumfluorid, Lanthanfluorid, Neodymfluorid, Dysprosiumfluorid, Aluminiumoxid, Yttriumfluorid, Ytterbiumfluorid und Siliziumdioxid sind und wobei für eine Betriebswellenlänge im Bereich von 150 nm bis 240 nm die mindestens eine Schicht (L) aus einem Material mit einem niedrigeren Brechungsindex n1 aus einem oder mehreren Materialien der Gruppe Aluminiumfluorid, Kryolith, Chiolith, Lithiumfluorid und Magnesiumfluorid ist, die mindestens eine Schicht (H) aus einem Material mit einem höheren Brechungsindex n2 aus einem oder mehreren Materialien der Gruppe Neodymfluorid, Gadoliniumfluorid, Dysprosiumfluorid, Lanthanfluorid und Aluminiumoxid ist und die Schichten (M) aus einem Material mit dem mittleren Brechungsindex n3 aus einem oder mehreren Materialien der Gruppe Magnesiumfluorid, Yttriumfluorid und Siliziumdioxid sind.

Es hat sich herausgestellt, dass das Vorsehen mindestens einer Schicht aus einem Material mit einem mittleren Brechungsindex n3 bei der Betriebswellenlänge eine Reduzierung der Gesamtzahl der Einzelschichten des dielektrischen Schichtsystem verglichen mit dem bisher bekannten reflektiven optischen Element bei vergleichbaren Eigenschaften erlaubt. Die Schichtmaterialien für das dielektrische Schichtsystem werden in Hinblick auf insbesondere eine Erhöhung der Reflektivität des reflektiven optischen Elements derart ausgewählt, dass sich der mittlere Brechungsindex n3 um mindestens 2% vom höheren Brechungsindex n1 und vom niedrigeren Brechungsindex n2 unterscheidet.

Dadurch können nicht nur die Produktionskosten verringert werden, sondern auch die Lebensdauer des reflektiven optischen Elements verlängert werden, da die Wahrscheinlichkeit des Auftretens von Spannungen oder Delamination verringert wird, was die mechanische Stabilität erhöht. Ferner kann eine höhere Breitbandigkeit erhalten werden.

Es sei darauf hingewiesen, dass für den Fall, dass im dielektrischen Schichtsystem jeweils mehr als eine Schicht mit niedrigerem Brechungsindex n1 bzw. höherem Brechungsindex n2 vorgesehen ist, diese besonders bevorzugt abwechselnd angeordnet sind. Außerdem sei darauf hingewiesen, dass bei mehr als einer Schicht aus einem Material mit höherem, niedrigerem oder mittlerem Brechungsindex, diese aus jeweils unterschiedlichen Materialien sein können, sofern die Bedingung n1<n3<n2 für jeweils benachbart angeordnete Schichten erfüllt ist. Um den Produktionsaufwand geringer zu halten, wird vorzugsweise jeweils immer nur ein Material verwendet.

Bei dem vorgeschlagenen reflektiven optischen Element können insbesondere die optischen Eigenschaften der metallischen Beschichtung gezielt positiv beeinflusst werden. Außerdem kann auch dessen Stabilität gegenüber Umwelteinflüssen und Strahlenschäden bei reduzierter Schichtenanzahl erhöht werden.

Bevorzugt ist die vom Substrat am weitesten entfernte Schicht des dielektrischen Schichtsystems eine Schicht aus einem Material mit mittlerem Brechungsindex n3, wodurch sich die Reflektivität des reflektiven optischen Elements bei der Betriebswellenlänge zusätzlich steigern lässt. Ferner kann dadurch das elektrische Feld der sich bei Strahlungsreflexion ausbildenden stehenden Welle minimiert werden, so dass weniger Sekundärelektronen emittiert werden, die sich negativ auf die Lebensdauer des reflektiven optischen Elements auswirken könnten.

Vorzugsweise weist das dielektrische Schichtsystem mindestens zwei Schichten aus einem Material mit mittlerem Brechungsindex n3 auf. Schon durch zwei Schichten aus einem Material mit mittlerem Brechungsindex n3 kann eine hinreichende Beeinflussung der optischen und sonstigen Eigenschaften beispielsweise der Breitbandigkeit des reflektiven optischen Elements bei deutlich reduzierter Schichtenanzahl erreicht werden. Bei drei, vier, fünf oder mehr Schichten aus einem Material mit mittlerem Brechungsindex n3 kann eine stärkere Beeinflussung der optischen und sonstigen Eigenschaften des reflektiven optischen Elements bei etwas weniger reduzierter Schichtenanzahl erreicht werden.

Vorteilhafterweise ist die zum Substrat zweitnächste Schicht des dielektrischen Schichtsystems aus einem Material mit mittlerem Brechungsindex n3, insbesondere wenn das dielektrische Schichtsystem mindestens zwei Schichten aus einem Material mit mittlerem Brechungsindex n3 aufweist und/oder die vom Substrat am weitesten entfernte Schicht des dielektrischen Schichtsystems eine Schicht aus dem Material mit mittlerem Brechungsindex n3 ist. Dadurch können die Strahlenresistenz der metallischen Beschichtung sowie die Reflektivität erhöht werden.

Bevorzugt ist das Substrat aus Quarz, titandotiertem Quarzglas, Kalziumfluorid oder Glaskeramik.

Vorteilhafterweise weist die metallische Beschichtung Aluminium, eine Aluminium-Silizium-Legierung, eine Aluminium-Mangan-Legierung, eine Aluminium-Silizium-Mangan-Legierung, Rhodium oder eine Kombination davon auf. Solche metallische Schichten können zu einer besonders breitbandigen Reflexion bzw. zu einer trotz Breitbandigkeit hohen Reflexion führen.

In einem weiteren Aspekt wird die Aufgabe gelöst durch ein optisches System für eine Lithographievorrichtung oder eine Mikroskopievorrichtung bzw. durch eine Lithographievorrichtung oder eine Mikroskopievorrichtung für eine Betriebswellenlänge im DUV- oder VUV-Wellenlängenbereich mit einem reflektiven optischen Element wie beschrieben. Bei den Mikroskopievorrichtungen kann es sich beispielsweise um Wafer- oder Maskeninspektionssysteme handeln.

Die vorliegende Erfindung soll unter Bezugnahme auf ein bevorzugtes Ausführungsbeispiel näher erläutert werden. Dazu zeigen
- Figur 1: eine schematische Prinzipskizze einer Lithographievorrichtung für den DUV- oder VUV-Wellenlängenbereich;
- Figur 2: eine schematische Prinzipskizze einer Mikroskopievorrichtung für den DUV- oder VUV-Wellenlängenbereich;
- Figur 3: schematisch den Aufbau eines reflektiven optischen Elements, das für den Einsatz in der Lithographie mit DUV bzw. VUV-Strahlung geeignet ist;
- Figur 4: schematisch eine erste Ausführungsform des vorgeschlagenen reflektiven optischen Elements;
- Figur 5: schematisch eine zweite Ausführungsform des vorgeschlagenen reflektiven optischen Elements.

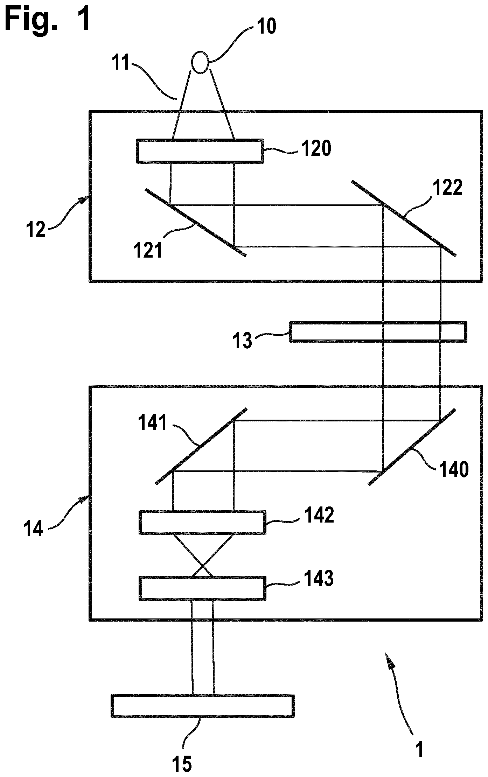

Figur 1 zeigt eine schematische Prinzipskizze einer Lithographievorrichtung 1 für den DUV- oder VUV-Wellenlängenbereich. Die Lithographievorrichtung 1 weist als wesentliche Bestandteile insbesondere zwei optische Systeme 12, 14 auf, ein Beleuchtungssystem 12 und Projektionssystem 14, die im vorliegenden Beispiel beide als katadioptrisches System ausgebildet sind. Für die Durchführung der Lithographie ist eine Strahlungsquelle 10 notwendig, besonders bevorzugt ein Excimerlaser, der beispielsweise bei 308 nm, 248 nm, 193 nm oder 157 nm emittiert und der integraler Bestandteil der Lithographievorrichtung 1 sein kann. Die von der Strahlungsquelle 10 emittierte Strahlung 11 wird mit Hilfe des Beleuchtungssystems 12 so aufbereitet, dass damit eine Maske 13, auch Retikel genannt, ausgeleuchtet werden kann. Dazu weist das Projektionssystem 12 mindestens ein transmittierendes optisches Element und ein reflektives optisches Element auf. Stellvertretend sind hier die Linse 120 dargestellt, das die Strahlung 11 beispielsweise bündelt, und die beiden Spiegel 121, 122. In bekannter Weise können im Beleuchtungssystem 12 verschiedenste transmittierende, reflektive und sonstige optische Elemente in beliebiger, auch komplexerer Weise miteinander kombiniert werden.

Die Maske 13 weist auf ihrer Oberfläche eine Struktur auf, die auf ein zu belichtendes Element 15, beispielsweise einen Wafer im Rahmen der Produktion von Halbleiterbauelementen, mithilfe des Projektionssystems 14 übertragen wird. Die Maske 13 kann in Abwandlungen auch als reflektives optisches Element ausgebildet sein.

Auch das Projektionssystem 14 weist mindestens ein transmittierendes optisches Element und ein reflektives optisches Element auf. In dem hier dargestellten Beispiel sind stellvertretend zwei Spiegel 140, 141 und zwei transmittierende optische Elemente 142, 143 dargestellt, die beispielsweise insbesondere dazu dienen, die Strukturen auf der Maske 13 auf die für die Belichtung des Wafers 15 gewünschte Größe zu verkleinern. Wie beim Belichtungssystem 12 können beim Projektionssystem 14 verschiedenste optische Elemente in bekannter Weise beliebig miteinander kombiniert werden.

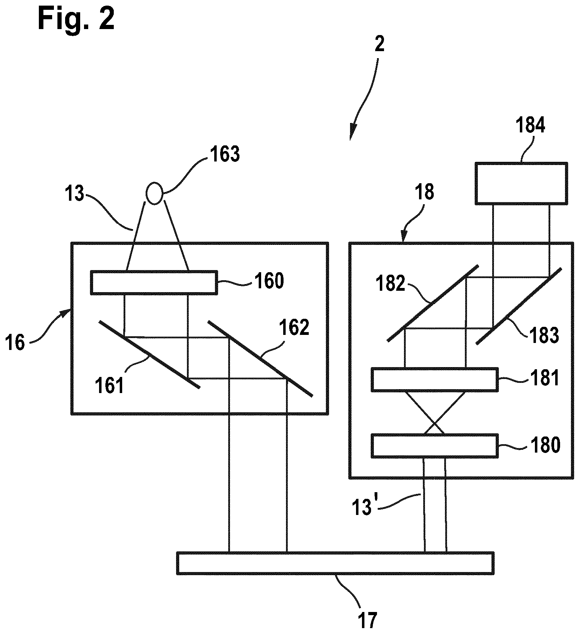

Figur 2 zeigt schematisch den Aufbau einer Mikroskopievorrichtung 2 für den DUV- oder VUV-Wellenlängenbereich. Sie ist im vorliegenden Beispiel als Waferinspektionssystem ausgebildet und umfasst ein Beleuchtungssystem 16 und ein Abbildungssystem 18, die im vorliegenden Beispiel zur besseren Übersicht nebeneinander dargestellt sind und beide als katadioptrisches System ausgebildet sind.

Für die Durchführung der Waferinspektion ist eine Strahlungsquelle 163 notwendig, besonders bevorzugt ein Excimerlaser, der beispielsweise bei 308 nm, 48 nm, 193 nm oder 157 nm emittiert und der integraler Bestandteil der Mikroskopievorrichtung 2 sein kann. Die von der Strahlungsquelle 163 emittierte Strahlung 13 wird mit Hilfe des Beleuchtungssystems 16 so aufbereitet, dass damit ein Wafer 17 ausgeleuchtet werden kann. Dazu weist das Projektionssystem 12 mindestens ein transmittierendes optisches Element und ein reflektives optisches Element auf. Stellvertretend sind hier die Linse 160 dargestellt, die die Strahlung 13 beispielsweise bündelt, und die beiden Spiegel 161, 162. In bekannter Weise können im Beleuchtungssystem 16 verschiedenste transmittierende, reflektive und sonstige optische Elemente in beliebiger, auch komplexerer Weise miteinander kombiniert werden.

Die an der Oberfläche des zu untersuchenden Wafers reflektierte Strahlung 13' (in Figur 2 parallel verschoben dargestellt) wird durch das Abbildungssystem 18 derart auf den Detektor 184 geleitet, dass Strukturen auf der Oberfläche des Wafers 17 bei Auftreffen auf den Detektor, beispielsweise ein ortsauflösender Flächendetektor, etwa auf Basis eines CCD(charge-coupled device)-Sensors, vergrößert dargestellt werden.

Auch das Abbildungssystem 18 weist mindestens ein transmittierendes optisches Element und ein reflektives optisches Element auf. In dem hier dargestellten Beispiel sind stellvertretend zwei transmittierende optische Elemente 180, 181 dargestellt, die beispielsweise insbesondere dazu dienen, die Strukturen auf der dem Wafer 17 zu vergrößern, sowie zwei Spiegel 182, 183. Wie beim Beleuchtungssystem 16 können beim Abbildungssystem 18 verschiedenste optische Elemente in bekannter Weise beliebig miteinander kombiniert werden.

Sowohl bei den Spiegeln 121, 122, 140, 141 als auch bei der Maske 13 aus Figur 1 wie bei den Spiegeln 161, 162, 182, 183 aus Figur 2 kann es sich um ein reflektives optisches Element, insbesondere für eine Betriebswellenlänge im Bereich von 150 nm bis 300 nm, handeln, das ein Substrat, ein dielektrisches Schichtsystem und eine metallische Beschichtung zwischen dem Substrat und dem dielektrischen Schichtsystem aufweist, wobei das dielektrische Schichtsystem eine Schicht aus einem Material mit einem niedrigerem Brechungsindex n1 bei der Betriebswellenlänge, eine Schicht aus einem Material mit einem höherem Brechungsindex n2 bei der Betriebswellenlänge und eine Schicht aus einem Material mit einem Brechungsindex n3 bei der Betriebswellenlänge aufweist mit n1<n3<n2, wobei Schichten mit einem niedrigerem Brechungsindex n1 und Schichten mit einem höheren Brechungsindex n2 abwechselnd angeordnet sind, wenn mehr als jeweils eine davon vorgesehen ist, und an mindestens einem Übergang von einer Schicht mit einem niedrigerem Brechungsindex n1 zu einer Schicht mit einem höherem Brechungsindex n2 bzw. von einer Schicht mit einem höherem Brechungsindex n2 zu einer Schicht mit einem niedrigerem Brechungsindex n1 eine Schicht mit einem mittleren Brechungsindex n3 angeordnet ist.

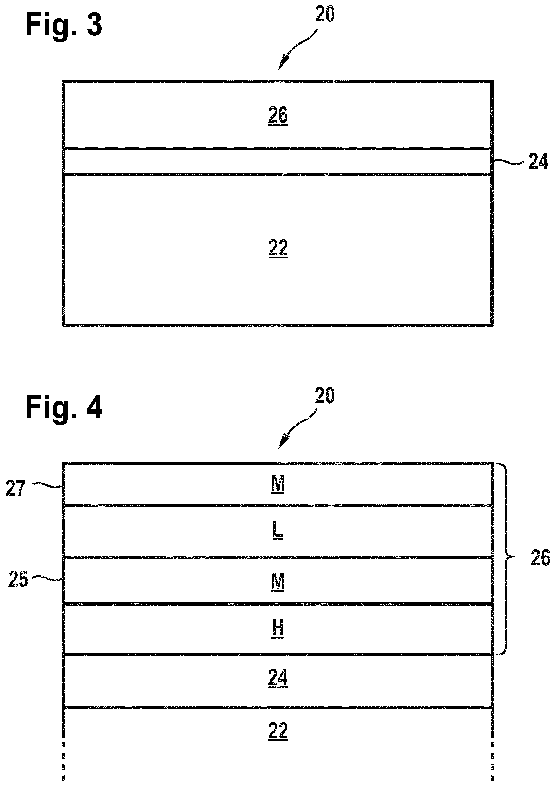

In Figur 3 ist schematisch der Aufbau eines reflektiven optischen Elements 20, das für den Einsatz in der Lithographie mit DUV- bzw. VUV-Strahlung geeignet ist, dargestellt. Auf einem Substrat 22 ist eine metallische Beschichtung 24 angeordnet. Das Substrat 22 kann beispielsweise aus Quarz, titandotiertem Quarzglas, Kalziumfluorid oder Glaskeramik sein. Die metallische Beschichtung 24 weist beispielsweise Aluminium, eine Aluminium-Silizium-Legierung, eine Aluminium-Mangan-Legierung, eine Aluminium-Silizium-Mangan-Legierung, Rhodium oder eine Kombination davon auf und dient primär als breitbandiger Spiegel. Um einerseits die metallische Beschichtung 24 zu schützen und andererseits die Eigenschaften der am reflektiven optischen Element 20 reflektierten Strahlung zu beeinflussen, ist auf der dem Substrat 22 abgewandten Seite der metallischen Beschichtung 24 als Abschluss zum Vakuum ein dielektrisches Schichtsystem 26 vorgesehen.

In einer beispielhaften Ausführungsform, die schematisch in Figur 4 dargestellt ist, weist das dielektrische Schichtsystem 26 eine Vierschichtenabfolge von (HMLM)m mit L der Schicht aus einem Material mit einem niedrigeren Brechungsindex n1 bei der Betriebswellenlänge, H der Schicht aus einem Material mit einem höheren Brechungsindex n2 bei der Betriebswellenlänge und M der Schicht aus einem Material mit einem Brechungsindex n3 bei der Betriebswellenlänge auf, wobei n1<n3<n2 sowie m die ganzzahlige Anzahl der Vierschichtenabfolge im dielektrischen Schichtsystem ist. Im hier dargestellten Beispiel ist m=1. Die Anzahl m kann insbesondere in Abhängigkeit von den gewünschten Eigenschaften des reflektiven optischen Elements beliebig gewählt werden.

Bevorzugt handelt es sich bei der am weitesten vom Substrat 22 entfernten Schicht 27 oder bei der zum Substrat 22 zweitnächsten Schicht 25 um eine Schicht M mit einem mittleren Brechungsindex n3. Im in Figur 4 dargestellten Beispiel sind sowohl die zweitnächste Schicht 25 als auch die am weitesten entfernte Schicht 27 aus einem Material mit einem mittleren Brechungsindex n3. Die in Figur 4 beispielhaft dargestellte Ausführungsform eines hier vorgeschlagenen reflektiven optischen Elements 20 weist in seinem dielektrischen Schichtsystem zusätzlichen zu den bekannten Schichten H und L mit höherem bzw. niedrigeren Brechungsindex n1, n2 somit zwei Schichten M mit einem mittleren Brechungsindex n3 auf.

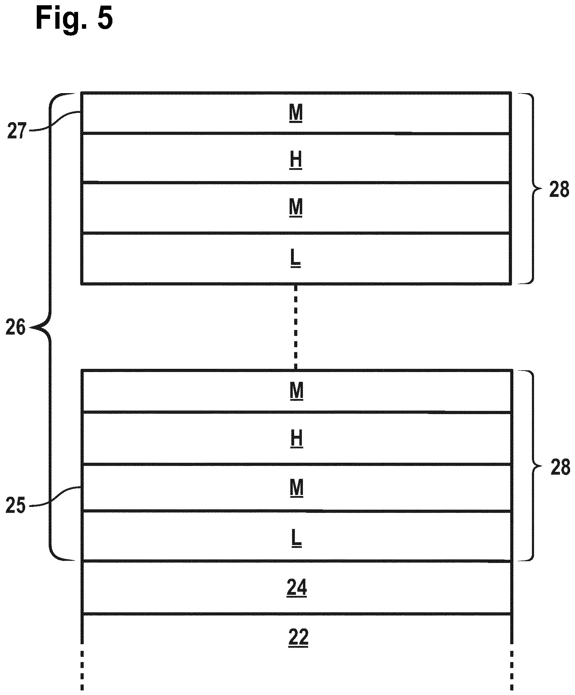

In einer in Figur 5 schematisch dargestellten Variante kann das dielektrische Schichtsystem 26 auch mehrere Vierschichtenabfolgen 28 von (LMHM)m aufweisen. Auch bei dem in Figur 5 dargestellten Beispiel handelt es sich bei der am weitesten vom Substrat 22 entfernten Schicht 27 und bei der zum Substrat 22 zweitnächsten Schicht 25 um eine Schicht M mit einem mittleren Brechungsindex n3. Das dielektrische Schichtsystem 26 weist 2*m Schichten M auf. In weiteren Varianten kann mindestens eine der in Verbindung mit Figur 4 oder Figur 5 genannten Vierschichtenabfolgen 28 unmittelbar auf der metallischen Beschichtung 24 und/oder als zum Vakuum abschließender bzw. am weitesten vom Substrat 22 entfernter Block des dielektrischen Schichtsystems 26 angeordnet sein und die übrigen Schichten des dielektrischen Schichtsystem können bevorzugt abwechselnd angeordnete H und L bzw. L und H Schichten sein. Auch an anderen Positionen innerhalb der dielektrischen Schichtabfolge können eine oder mehrere Vierschichtenabfolgen 28 angeordnet sein. Bei den Materialien für die L und H Schichten kann es sich um immer jeweils ein Material oder auch, wie in der US 5,850,309 beschrieben, blockweise um unterschiedliche Materialien handeln. Das Material für die M Schichten wird in Abhängigkeit der Materialien der jeweils angrenzend angeordneten H und L Schichten mit der Maßgabe ausgewählt, dass bei der Betriebswellenlänge, für die das reflektive optische Element optimiert ist, n1<n3<n2 gilt.

Erfindungsgemäß ist bei reflektiven optischen Elementen für eine Betriebswellenlänge im Bereich zwischen 240 nm und 300 nm die Schicht L aus einem Material mit einem niedrigeren Brechungsindex n1 aus einem oder mehreren Materialien der Gruppe Aluminiumfluorid, Kryolith, Chiolith, Lithiumfluorid und Magnesiumfluorid, die Schicht H aus einem Material mit einem höheren Brechungsindex n2 aus einem oder mehreren Materialien der Gruppe Yttriumoxid, Hafniumoxid, Scandiumoxid, Zirkoniumoxid, Aluminiumnitrid und synthetischem Diamant und die Schicht M aus einem Material mit einem mittleren Brechungsindex n3 aus einem oder mehreren Materialien der Gruppe Bariumfluorid, Gadoliniumfluorid, Lanthanfluorid, Neodymfluorid, Dysprosiumfluorid, Aluminiumoxid, Yttriumfluorid, Ytterbiumfluorid und Siliziumdioxid.

Bei reflektiven optischen Elementen für eine Betriebswellenlänge im Bereich von 150 nm bis 240 nm ist die Schicht L aus einem Material mit einem niedrigeren Brechungsindex n1 aus einem oder mehreren Materialien der Gruppe Aluminiumfluorid, Kryolith, Chiolith, Lithiumfluorid und Magnesiumfluorid, die Schicht H aus einem Material mit einem höheren Brechungsindex n2 aus einem oder mehreren Materialien der Gruppe Neodymfluorid, Gadoliniumfluorid, Dysprosiumfluorid, Lanthanfluorid und Aluminiumoxid und die Schicht M aus einem Material mit dem mittleren Brechungsindex n3 aus einem oder mehreren Materialien der Gruppe Magnesiumfluorid, Yttriumfluorid und Siliziumdioxid.

Die Schichtmaterialien für das dielektrische Schichtsystem werden in Hinblick auf insbesondere eine Erhöhung der Reflektivität des reflektiven optischen Elements derart ausgewählt, dass sich der mittlere Brechungsindex n3 um mindestens 2% vom höheren Brechungsindex n1 und vom niedrigeren Brechungsindex n2 unterscheidet.

### Beispiel

Ein reflektives optisches Element aus einem Quarzsubstrat mit metallischer Beschichtung aus Aluminium weist ein dielektrisches Schichtsystem mit fünf Vierschichtabfolgen der Art LMHM, also 20 Einzelschichten auf. Es ist für den Einsatz mit einem Excimerlaser ausgelegt, der bei 193 nm emittiert.

Die Reflektivität dieses reflektiven optischen Elements mit einer entsprechenden Kombination von zuvor für eine Betriebswellenlänge im Bereich von 150 nm bis 240 nm als geeignet genannten hoch-, mittel- und niedrigbrechenden Materialien bei einem Einfallswinkel von 10° zur Flächennormalen und unpolarisierter Strahlung liegt über 95% für Wellenlängen zwischen 190 nm und 215 nm, um danach bis 250 nm auf Werte zwischen 95% und 90% zu sinken. Zwischen 250 nm und 300 nm liegt die Reflektivität noch im Bereich zwischen ca. 88% und knapp 90%. Ein reflektives optisches Element mit vergleichbarer Reflektivität und vergleichbaren Eigenschaften, aber ohne mittelbrechende Schichten, weist ein dielektrisches Schichtsystem mit signifikant größerer Anzahl Einzellagen auf.

In Varianten mit anstelle von Aluminium einer metallischen Beschichtungen aus Aluminium-Silizium-Legierung, Aluminium-Mangan-Legierung, Aluminium-Silizium-Mangan-Legierung, Rhodium oder einer Kombination davon bzw. mit Aluminium wurden vergleichbare Ergebnisse erhalten. Dies gilt auch für Varianten, die für Excimerlaser optimiert wurden, die bei anderen Wellenlängen emittieren, u.a. mit Materialien, die für eine Betriebswellenlänge zwischen 240 nm und 300 nm geeignet sind.

Es sei darauf hingewiesen, dass die hier vorgeschlagenen reflektiven optischen Elemente auch bei fester Wellenlänge der einfallenden Strahlung, aber über einem ausgedehnten Einfallswinkelbereich von mehreren 10° eine Reflektivität von über 90% aufweisen können.

## Patentansprüche

1. Reflektives optisches Element für eine Betriebswellenlänge zwischen 150 nm und 300 nm im DUV- oder VUV-Wellenlängenbereich, aufweisend ein Substrat, ein dielektrisches Schichtsystem und eine metallische Beschichtung zwischen dem Substrat und dem dielektrischen Schichtsystem, bei dem das dielektrische Schichtsystem mindestens jeweils eine Schicht aus einem Material mit einem niedrigeren Brechungsindex n1 bei der Betriebswellenlänge, sowie eine Schicht aus einem Material mit einem höheren Brechungsindex n2 bei der Betriebswellenlänge aufweist, **dadurch gekennzeichnet, dass** das dielektrische Schichtsystem des Weiteren Schichten aus einem Material mit einem Brechungsindex n3 bei der Betriebswellenlänge aufweist mit n1<n3<n2, wobei an Übergängen von einer Schicht mit einem niedrigeren Brechungsindex n1 zu einer Schicht mit einem höheren Brechungsindex n2 bzw. von einer Schicht mit einem höheren Brechungsindex n2 zu einer Schicht mit einem niedrigeren Brechungsindex n1 eine Schicht mit einem mittleren Brechungsindex n3 angeordnet ist, derart dass das dielektrische Schichtsystem (26) eine Vierschichtenabfolge von (LMHM)m oder (HMLM)m mit L der Schicht aus einem Material mit einem niedrigeren Brechungsindex n1 bei der Betriebswellenlänge, H der Schicht aus einem Material mit einem höheren Brechungsindex n2 bei der Betriebswellenlänge und M jeweils der Schicht aus einem Material mit einem Brechungsindex n3 bei der Betriebswellenlänge aufweist, wobei n1<n3<n2 sowie m die Anzahl der Vierschichtenabfolge im dielektrischen Schichtsystem ist,
wobei für eine Betriebswellenlänge im Bereich zwischen 240 nm und 300 nm die mindestens eine Schicht (L) aus einem Material mit einem niedrigeren Brechungsindex n1 aus einem oder mehreren Materialien der Gruppe Aluminiumfluorid, Kryolith, Chiolith, Lithiumfluorid und Magnesiumfluorid ist, die mindestens eine Schicht (H) aus einem Material mit einem höheren Brechungsindex n2 aus einem oder mehreren Materialien der Gruppe Yttriumoxid, Hafniumoxid, Scandiumoxid, Zirkoniumoxid, Aluminiumnitrid und synthetischem Diamant ist und die Schichten (M) aus einem Material mit einem mittleren Brechungsindex n3 aus einem oder mehreren Materialien der Gruppe Bariumfluorid, Gadoliniumfluorid, Lanthanfluorid, Neodymfluorid, Dysprosiumfluorid, Aluminiumoxid, Yttriumfluorid, Ytterbiumfluorid und Siliziumdioxid sind und
wobei für eine Betriebswellenlänge im Bereich von 150 nm bis 240 nm die mindestens eine Schicht (L) aus einem Material mit einem niedrigeren Brechungsindex n1 aus einem oder mehreren Materialien der Gruppe Aluminiumfluorid, Kryolith, Chiolith, Lithiumfluorid und Magnesiumfluorid ist, die mindestens eine Schicht (H) aus einem Material mit einem höheren Brechungsindex n2 aus einem oder mehreren Materialien der Gruppe Neodymfluorid, Gadoliniumfluorid, Dysprosiumfluorid, Lanthanfluorid und Aluminiumoxid ist und die Schichten (M) aus einem Material mit dem mittleren Brechungsindex n3 aus einem oder mehreren Materialien der Gruppe Magnesiumfluorid, Yttriumfluorid und Siliziumdioxid sind.

2. Reflektives optisches Element nach Anspruch 1, **dadurch gekennzeichnet, dass** die vom Substrat (22) am weitesten entfernte Schicht (27) des dielektrischen Schichtsystems (26) eine Schicht (M) aus einem Material mit mittlerem Brechungsindex n3 ist.

3. Reflektives optisches Element nach Anspruch 1 oder 2, **dadurch gekennzeichnet, dass** die zum Substrat (22) zweitnächste Schicht (25) des dielektrischen Schichtsystem (26) aus einem Material (M) mit mittlerem Brechungsindex n3 ist.

4. Reflektives optisches Element nach einem der Ansprüche 1 bis 3, **dadurch gekennzeichnet, dass** die metallische Beschichtung (24) Aluminium, eine Aluminium-Silizium-Legierung, eine Aluminium-Mangan-Legierung, eine Aluminium-Silizium-Mangan-Legierung, Rhodium oder eine Kombination davon aufweist.

5. Optisches System für eine Lithographievorrichtung oder eine Mikroskopievorrichtung mit einem reflektiven optischen Element nach einem der Ansprüche 1 bis 4.

6. Lithographievorrichtung für eine Betriebswellenlänge im DUV- oder VUV-Wellenlängenbereich mit einem reflektiven optischen Element nach einem der Ansprüche 1 bis 4.

7. Mikroskopvorrichtung für eine Betriebswellenlänge im DUV- oder VUV-Wellenlängenbereich mit einem reflektiven optischen Element nach einem der Ansprüche 1 bis 4.

## Claims

1. Reflective optical element for an operating wavelength of between 150 nm and 300 nm in the DUV or VUV wavelength range, comprising a substrate, a dielectric layer system and a metallic coating between the substrate and the dielectric layer system, wherein the dielectric layer system comprises at least respectively one layer composed of a material having a lower refractive index n1 at the operating wavelength, and also one layer composed of a material having a higher refractive index n2 at the operating wavelength, **characterized in that** the dielectric layer system furthermore comprises layers composed of a material having a refractive index n3 at the operating wavelength, where n1<n3<n2, wherein a layer having a medium refractive index n3 is arranged at transitions from a layer having a lower refractive index n1 to a layer having a higher refractive index n2 and/or from a layer having a higher refractive index n2 to a layer having a lower refractive index n1, in such a way that the dielectric layer system (26) comprises a four-layer sequence of (LMHM)m or (HMLM)m where L is the layer composed of a material having a lower refractive index n1 at the operating wavelength, H is the layer composed of a material having a higher refractive index n2 at the operating wavelength and M is in each case the layer composed of a material having a refractive index n3 at the operating wavelength, wherein n1<n3<n2, and m is the number of four-layer sequences in the dielectric layer system,
wherein for an operating wavelength in the range of between 240 nm and 300 nm, the at least one layer (L) composed of a material having a lower refractive index n1 is composed of one or more materials of the group aluminium fluoride, cryolite, chiolite, lithium fluoride and magnesium fluoride, the at least one layer (H) composed of a material having a higher refractive index n2 is composed of one or more materials of the group yttrium oxide, hafnium oxide, scandium oxide, zirconium oxide, aluminium nitride and synthetic diamond, and the layers (M) composed of a material having a medium refractive index n3 are composed of one or more materials of the group barium fluoride, gadolinium fluoride, lanthanum fluoride, neodymium fluoride, dysprosium fluoride, aluminium oxide, yttrium fluoride, ytterbium fluoride and silicon dioxide, and
wherein for an operating wavelength in the range of 150 nm to 240 nm, the at least one layer (L) composed of a material having a lower refractive index n1 is composed of one or more materials of the group aluminium fluoride, cryolite, chiolite, lithium fluoride and magnesium fluoride, the at least one layer (H) composed of a material having a higher refractive index n2 is composed of one or more materials of the group neodymium fluoride, gadolinium fluoride, dysprosium fluoride, lanthanum fluoride and aluminium oxide, and the layers (M) composed of a material having the medium refractive index n3 are composed of one or more materials of the group magnesium fluoride, yttrium fluoride and silicon dioxide.

2. Reflective optical element according to Claim 1, **characterized in that** the layer (27) of the dielectric layer system (26) which is the furthest away from the substrate (22) is a layer (M) composed of a material having a medium refractive index n3**.**

3. Reflective optical element according to Claim 1 or **2, characterized in that** the layer (25) of the dielectric layer system (26) which is second closest to the substrate (22) is composed of a material (M) having a medium refractive index n3**.**

4. Reflective optical element according to any of Claims 1 to 3, **characterized in that** the metallic coating (24) comprises aluminium, an aluminium-silicon alloy, an aluminium-manganese alloy, an aluminium-silicon-manganese alloy, rhodium or a combination thereof.

5. Optical system for a lithography device or a microscopy device comprising a reflective optical element according to any of Claims 1 to 4.

6. Lithography device for an operating wavelength in the DUV or VUV wavelength range comprising a reflective optical element according to any of Claims 1 to 4.

7. Microscope device for an operating wavelength in the DUV or VUV wavelength range comprising a reflective optical element according to any of Claims 1 to 4.

## Revendications

1. Élément optique réfléchissant pour une longueur d'onde de fonctionnement entre 150 nm et 300 nm dans la plage de longueurs d'onde DUV ou VUV, présentant un substrat, un système de couches diélectriques et un revêtement métallique entre le substrat et le système de couches diélectriques, dans lequel le système de couches diélectriques présente au moins respectivement une couche en un matériau ayant un indice de réfraction plus faible n1 à la longueur d'onde de fonctionnement, et une couche en un matériau ayant un indice de réfraction plus élevé n2 à la longueur d'onde de fonctionnement, **caractérisé en ce que** le système de couches diélectriques présente en outre des couches en un matériau ayant un indice de réfraction n3 à la longueur d'onde de fonctionnement, avec n1<n3<n2, dans lequel, aux transitions d'une couche ayant un indice de réfraction plus faible n1 à une couche ayant un indice de réfraction plus élevé n2, ou d'une couche ayant un indice de réfraction plus élevé n2 à une couche ayant un indice de réfraction plus faible n1, est agencée une couche ayant un indice de réfraction intermédiaire n3, de telle sorte que le système de couches diélectriques (26) est une séquence de quatre couches de (LMHM)m ou (HMLM)m avec L la couche en un matériau ayant un indice de réfraction plus faible n1 à la longueur d'onde de fonctionnement, H la couche en un matériau ayant un indice de réfraction plus élevé n2 à la longueur d'onde de fonctionnement et M respectivement la couche en un matériau ayant un indice de réfraction n3 à la longueur d'onde de fonctionnement, où n1<n3<n2 et m est le nombre de séquences de quatre couches dans le système de couches diélectriques,
dans lequel, pour une longueur d'onde de fonctionnement comprise entre 240 nm et 300 nm, l'au moins une couche (L) en un matériau ayant un indice de réfraction plus faible n1 est en un ou plusieurs matériaux du groupe composé par le fluorure d'aluminium, la cryolithe, la chiolithe, le fluorure de lithium et le fluorure de magnésium, l'au moins une couche (H) en un matériau ayant un indice de réfraction plus élevé n2 est en un ou plusieurs matériaux du groupe composé par l'oxyde d'yttrium, l'oxyde d'hafnium, l'oxyde de scandium, l'oxyde de zirconium, le nitrure d'aluminium et le diamant synthétique, et les couches (M) en un matériau ayant un indice de réfraction intermédiaire n3 sont en un ou plusieurs matériaux du groupe composé par le fluorure de baryum, le fluorure de gadolinium, le fluorure de lanthane, le fluorure de néodyme, le fluorure de dysprosium, l'oxyde d'aluminium, le fluorure d'yttrium, le fluorure d'ytterbium et le dioxyde de silicium, et
dans lequel, pour une longueur d'onde de fonctionnement dans la plage de 150 nm à 240 nm, l'au moins une couche (L) en un matériau ayant un indice de réfraction plus faible n1 est en un ou plusieurs matériaux du groupe composé par le fluorure d'aluminium, la cryolithe, la chiolithe, le fluorure de lithium et le fluorure de magnésium, l'au moins une couche (H) en un matériau ayant un indice de réfraction plus élevé n2 est en un ou plusieurs matériaux du groupe composé par le fluorure de néodyme, le fluorure de gadolinium, le fluorure de dysprosium, le fluorure de lanthane et l'oxyde d'aluminium, et les couches (M) en un matériau ayant un indice de réfraction intermédiaire n3 sont en un ou plusieurs matériaux du groupe composé par le fluorure de magnésium, le fluorure d'yttrium et le dioxyde de silicium.

2. Élément optique réfléchissant selon la revendication 1, **caractérisé en ce que** la couche (27) du système de couches diélectriques (26) la plus éloignée du substrat (22) est une couche (M) en un matériau ayant un indice de réfraction intermédiaire n3.

3. Élément optique réfléchissant selon la revendication 1 ou 2, **caractérisé en ce que** la deuxième couche (25) du système de couches diélectriques (26) la plus proche du substrat (22) est en un matériau (M) ayant un indice de réfraction intermédiaire n3.

4. Élément optique réfléchissant selon l'une quelconque des revendications 1 à 3, **caractérisé en ce que** le revêtement métallique (24) présente de l'aluminium, un alliage aluminium-silicium, un alliage aluminium-manganèse, un alliage aluminium-silicium-manganèse, du rhodium ou une combinaison de ceux-ci.

5. Système optique pour un dispositif de lithographie ou un dispositif de microscopie avec un élément optique réfléchissant selon l'une quelconque des revendications 1 à 4.

6. Dispositif de lithographie pour une longueur d'onde de fonctionnement dans la plage de longueurs d'onde DUV ou VUV, avec un élément optique réfléchissant selon l'une quelconque des revendications 1 à 4.

7. Dispositif de microscope pour une longueur d'onde de fonctionnement dans la plage de longueurs d'onde DUV ou VUV, avec un élément optique réfléchissant selon l'une quelconque des revendications 1 à 4.
